# EUROPEAN PATENT APPLICATION

(11) **EP 2 858 062 A1**
(43) Date of publication of application: **08.04.2015**
(21) Application number: 14275084.3
(22) Date of filing: 16.04.2014
(51) Int. Cl.: G09F 3/20, G06F 1/32, G06K 19/07, H03K 23/00

(54) **Sleep cycle counting device, sleep cycle counting method and electronic tag device using the same**

(30) Priority: 04.10.2013 KR 20130118548
(71) Applicant: Samsung Electro-Mechanics Co., Ltd., Suwon-Si, Gyeonggi-Do (KR)
(72) Inventor: Lee,, Kwang Mook, Gyeonggi-Do (KR)
(74) Representative: Potter Clarkson LLP

(57) **Abstract**

A sleep cycle counting device may include an oscillating unit receiving a voltage having a predetermined level and outputting an oscillating signal, a dividing unit dividing the oscillating signal, a sleep cycle setting unit setting a sleep cycle, a dividing ratio controlling unit varying a dividing ratio of the dividing unit according to the sleep cycle, and a sleep mode controlling unit counting the number of clocks in the divided oscillating signal and outputting a wakeup or a sleep signal.

## Description

### CROSS-REFERENCE TO RELATED APPLICATIONS

This application claims the benefit of Korean Patent Application No. 10-2013-0118548 filed on October 4, 2013, with the Korean Intellectual Property Office, the disclosure of which is incorporated herein by reference.

### BACKGROUND

The present disclosure relates to a sleep cycle counting device, a sleep cycle counting method, and an electronic tag device using the same.

In an application using battery power, a sleep mode function is generally recognized as being very important.

Such a sleep mode function has been adopted for use in devices in a wide range of fields in order to reduce power consumption thereof. Particularly, electronic shelf label tags are powered by batteries; a low power design including a sleep mode function is recognized as being important.

In general, a sleep mode function, which powers off the majority of blocks of a device, such as a central processing unit (CPU), a memory, and the like, in a sleep mode and only retains a power-on state in a function block counting a sleep cycle, is a scheme of changing the state of the application device to a state thereof in which a minimal amount of power is consumed.

However, since a sleep cycle counting scheme according to the related art commonly counts an oscillating signal having a fixed frequency, regardless of the sleep cycle, it is difficult to significantly reduce power consumption.

### SUMMARY

An exemplary embodiment in the present disclosure may provide a sleep cycle counting device, a sleep cycle counting method, and an electronic tag device using the same, capable of reducing power consumption.

According to an exemplary embodiment in the present disclosure, a sleep cycle counting device may include: an oscillating unit receiving a voltage having a predetermined level and outputting an oscillating signal; a dividing unit dividing the oscillating signal; a sleep cycle setting unit setting a sleep cycle; a dividing ratio controlling unit varying a dividing ratio of the dividing unit according to the sleep cycle; and a sleep mode controlling unit counting the number of clocks in the divided oscillating signal and outputting a wakeup or a sleep signal.

The dividing ratio controlling unit may vary the dividing ratio in proportion to the sleep cycle.

The sleep cycle counting device may further include a lookup table including dividing ratio information according to the sleep cycle, wherein the dividing ratio controlling unit may vary the dividing ratio according to the dividing ratio information stored in the lookup table.

The oscillating unit may be an RC oscillator.

According to an exemplary embodiment in the present disclosure, a sleep cycle counting method may include: setting a sleep cycle; varying a dividing ratio according to the sleep cycle; dividing an oscillating signal using the dividing ratio; counting the number of clocks in the divided oscillating signal; and outputting a wakeup signal when a sleep time according to the sleep cycle expires as a result of counting the number of clocks.

The sleep cycle counting method may further include counting the number of clocks in the divided oscillating signal after the outputting of the wakeup signal; and outputting a sleep signal when a wakeup time according to the sleep cycle expires as a result of counting the number of clocks.

According to an exemplary embodiment in the present disclosure, an electronic tag device may include: a communications unit communicating with a server; an oscillating unit receiving a voltage having a predetermined level and outputting an oscillating signal; a sleep cycle counting unit setting a sleep cycle of the communications unit, dividing an output frequency of the oscillating signal according to the sleep cycle, and counting the number of clocks in the divided oscillating signal to output a wakeup or a sleep signal; and a controlling unit switching the communications unit to a wakeup or a sleep mode according to the the wakeup or the sleep signal output by the sleep cycle counting unit.

The sleep cycle counting unit may include: a dividing unit dividing the oscillating signal; a sleep cycle setting unit setting the sleep cycle; a dividing ratio controlling unit varying the dividing ratio of the diving unit according to the sleep cycle; and a sleep mode controlling unit counting the number of clocks in the divided oscillating signal and outputting the wakeup or the sleep signal.

The dividing ratio controlling unit may vary the dividing ratio in proportion to the sleep cycle.

The dividing ratio controlling unit may include a lookup table including dividing ratio information according to the sleep cycle and varies the dividing ratio according to the dividing ratio information stored in the lookup table.

The oscillating unit may be an RC oscillator.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a configuration diagram illustrating a sleep cycle counting device according to an exemplary embodiment of the present disclosure;
FIG. 2 is a configuration diagram illustrating a sleep cycle counting device according to another exemplary embodiment of the present disclosure;
FIG. 3 is a flowchart illustrating a sleep cycle counting method according to an exemplary embodiment of the present disclosure;
FIG. 4 is a flowchart illustrating a sleep cycle counting method according to another exemplary embodiment of the present disclosure;
FIG. 5 is a configuration diagram illustrating an electronic shelf label tag device according to an exemplary embodiment of the present disclosure;
FIG. 6 is a configuration diagram illustrating details of the electronic shelf label tag device of FIG. 5; and
FIG. 7 is a configuration diagram illustrating details of a sleep cycle counting unit of FIG. 6.

### DETAILED DESCRIPTION

Hereinafter, embodiments of the present disclosure will be described in detail with reference to the accompanying drawings.

The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art.

Throughout the drawings, the same or like reference numerals will be used to designate the same or like elements.

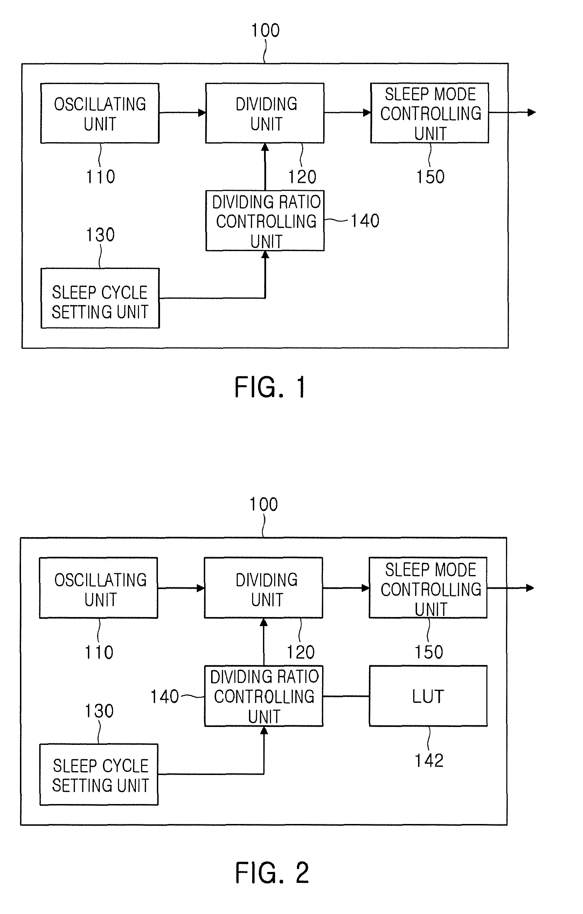

FIG. 1 is a configuration diagram illustrating a sleep cycle counting device according to an exemplary embodiment of the present disclosure and FIG. 2 is a configuration diagram illustrating a sleep cycle counting device according to another exemplary embodiment of the present disclosure.

Referring to FIG. 1, a sleep cycle counting device 100 according to an exemplary embodiment of the present disclosure may include an oscillating unit 110, a dividing unit 120, a sleep cycle setting unit 130, a dividing ratio controlling unit 140, and a sleep mode controlling unit 150.

The oscillating unit 110 may generate an oscillating signal to output the same to the dividing unit 120. Here, the oscillating unit 110 may include an RC oscillator configured of resistance and capacitance. Here, the oscillating unit 110 may correct a frequency of the oscillating signal by adjusting resistance and capacitance values.

The dividing unit 120 may divide the oscillating signal received from the oscillating unit 110 to output the same to the sleep mode controlling unit 150. Here, the dividing unit 140 may divide the oscillating signal at a dividing ratio varied by the dividing ratio controlling unit 140.

The sleep cycle setting unit 130 may set a sleep cycle to output the same to the dividing ratio controlling unit 140. Here, the sleep cycle setting unit 130 may set the sleep cycle corresponding to sleep mode information which is input from the outside or is preset.

The dividing ratio controlling unit 140 may vary the dividing ratio of the dividing unit 120 according to the sleep cycle set by the sleep cycle setting unit 130.

According to an exemplary embodiment of the present disclosure, the dividing ratio controlling unit 140 may vary the dividing ratio in proportion to the sleep cycle which is set by the sleep cycle setting unit 130. That is, the dividing ratio controlling unit 140 may vary the dividing ratio in a manner such that the dividing unit 120 has an increased dividing ratio value as the sleep cycle is increased.

According to an exemplary embodiment of the present disclosure, as shown in FIG. 2, the sleep cycle counting device 100 may further include a lookup table 142, including dividing ratio information according to the sleep cycle. Here, the dividing ratio controlling unit 140 may vary the dividing ratio according to the dividing ratio information stored in the lookup table 142.

The sleep mode controlling unit 150 may count the number of clocks in the oscillating signal which is divided by the dividing unit 120 and output a wakeup or a sleep signal.

Here, when the sleep mode controlling unit 150 counts the oscillating signal divided by the dividing unit 120, an operating current flows to thereby cause power consumption. Therefore, as the sleep cycle is increased, the sleep mode controlling unit 150 counts the oscillating signal divided at a larger dividing ratio, such that the number of counting is reduced, whereby the power consumption may be significantly reduced.

For example, in the case in which the frequency of the oscillating signal generated by the oscillating unit 110 is 31.25 kHz and a sleep time of the sleep cycle set by the sleep cycle setting unit 130 is 320 µs, a minimum unit of the counting may become 32 µs, and when a counting value of the oscillating signal becomes 10, the sleep mode controlling unit 150 may output a wakeup signal. However, in the case in which the dividing ratio controlling unit 140 varies the dividing ratio to 2, the minimum unit of the counting becomes 64 µs, and when the counting value of the oscillating signal becomes 5, the sleep mode controlling unit 150 may output the wakeup signal. Therefore, the operating current is reduced to 1/2 as compared with before the dividing ratio is varied to 2, whereby the power consumption may be reduced.

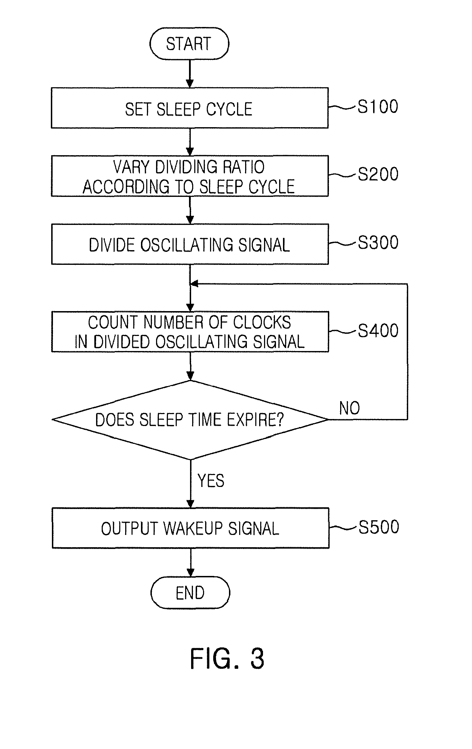

FIG. 3 is a flowchart illustrating a sleep cycle counting method according to an exemplary embodiment of the present disclosure.

Referring to FIG. 3, a sleep cycle counting method according to an exemplary embodiment of the present disclosure may be implemented by the sleep cycle counting device 100 of FIG. 1. However, a method proposed according to the present inventive concept is not limited thereto.

In the sleep cycle counting method according to an exemplary embodiment of the present disclosure, first, the sleep cycle setting unit 130 may set a sleep cycle (S100). Here, the sleep cycle may correspond to sleep mode information which is input from the outside or is preset.

If the sleep cycle is set, the dividing ratio controlling unit 140 may determine a dividing ratio according to the sleep cycle (S200). Here, the dividing ratio may be varied in proportion to the sleep cycle. In addition, the dividing ratio controlling unit 140 may vary the dividing ratio according to the sleep cycle set with reference to a pre-prepared lookup table and a frequency of an oscillating signal.

Next, the dividing unit 120 may divide the oscillating signal using the dividing ratio varied by the dividing ratio controlling unit 140 (S300). Here, as the oscillating signal is divided at an increased dividing ratio value, the oscillating signal may be divided to a low frequency.

Next, the sleep mode controlling unit 150 may count the number of clocks in the divided oscillating signal (S400) and output a wakeup signal (S500) when the sleep time according to the sleep cycle expires, as a result of counting the number of clocks in the divided oscillating signal.

According to the above-described exemplary embodiment of the present disclosure, the number of counting may be reduced by counting the oscillating signal which has been divided to the low frequency according to the sleep cycle, whereby power consumption in the counting operation may be reduced.

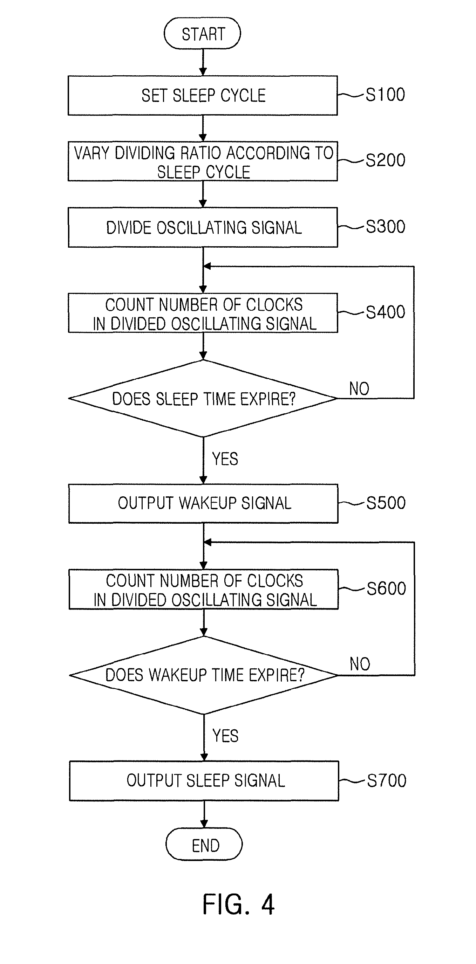

FIG. 4 is a flowchart illustrating a sleep cycle counting method according to another exemplary embodiment of the present disclosure.

Referring to FIG. 4, a sleep cycle counting method according to another exemplary embodiment of the present disclosure may include setting a sleep cycle (S100), varying a dividing ratio according to the sleep cycle (S200), dividing an oscillating signal using the varied dividing ratio (S300), counting the number of clocks in the divided oscillating signal (S400), outputting a wakeup signal when a sleep time according to the sleep cycle expires as a result of counting the number of clocks (S500), counting the number of clocks in the divided oscillating signal (S600), and outputting a sleep signal when a wakeup time according to the sleep cycle expires as a result of counting the number of clocks (S700).

The operation of setting the sleep cycle (S100) through the operation of outputting the wakeup signal (S500) in this exemplary embodiment of the present disclosure are the same as those in the previous exemplary embodiment of the present disclosure. Therefore, a detailed description thereof will be omitted.

In the sleep cycle counting method according to this exemplary embodiment of the present disclosure, after the wakeup signal is output, the sleep mode controlling unit 150 may count the number of clocks in the oscillating signal (S600) . Here, the counting operation of the sleep mode controlling unit 150 may be performed in succession to the counting operation before the outputting of the wakeup signal.

Next, as a result of counting the number of clocks, when the wakeup time according to the set sleep cycle expires, the sleep mode controlling unit 150 may output the sleep signal (S700).

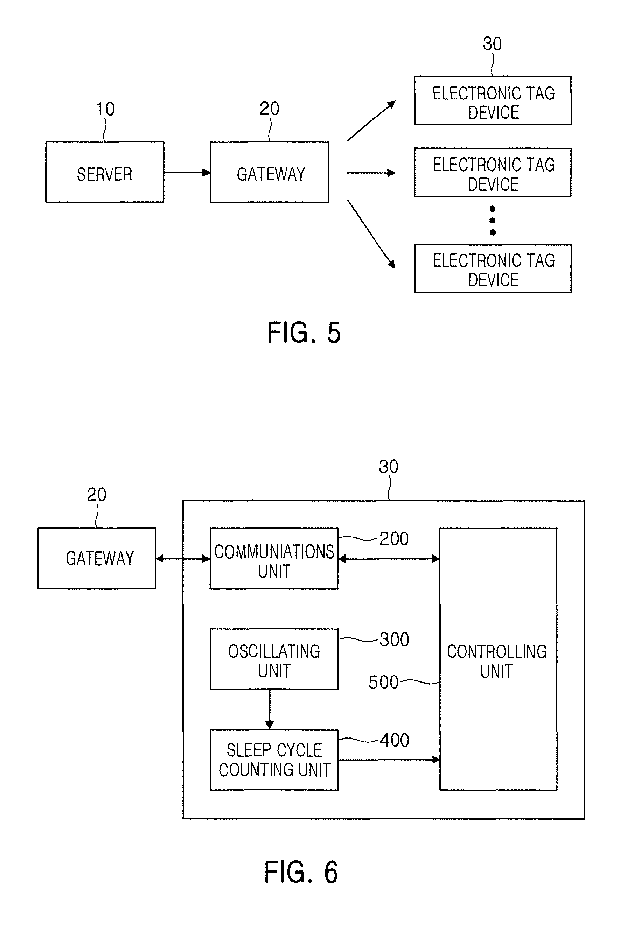

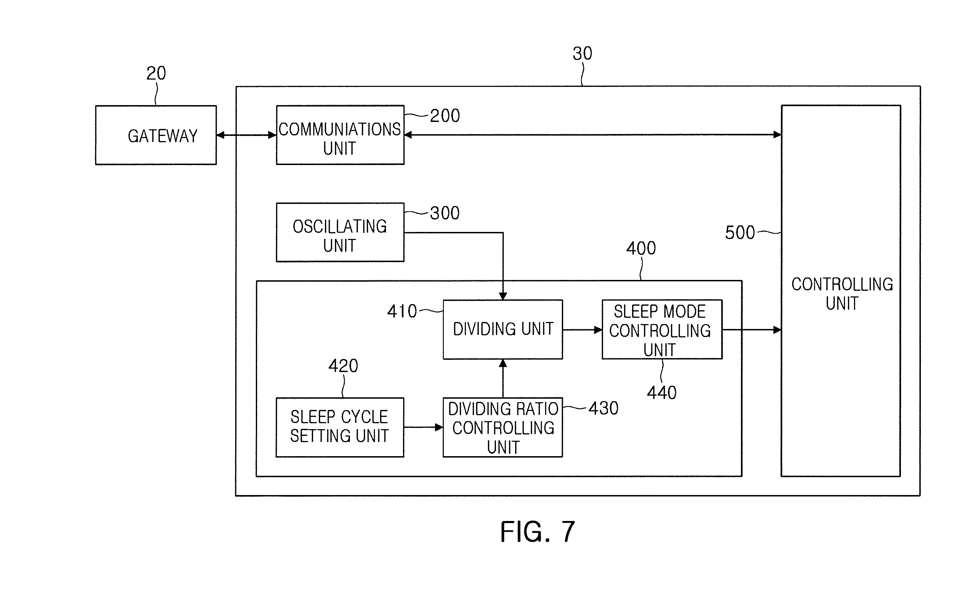

FIG. 5 is a configuration diagram illustrating an electronic shelf label tag device according to an exemplary embodiment of the present disclosure, FIG. 6 is a configuration diagram illustrating details of the electronic shelf label tag device of FIG. 5, and FIG. 7 is a configuration diagram illustrating details of a sleep cycle counting unit of FIG. 6.

Referring to FIGS. 5 and 6, an electronic tag device 30 according to an exemplary embodiment of the present disclosure may communicate with a server 10 through a gateway 20. Here, the electronic tag device 30 may serve to receive and display product information, and the like from the server 10 through the gateway 20. Since these data communications and product information display technologies are well-known to those skilled in the art, a detailed description thereof will be omitted.

Hereinafter, the electronic tag device using the sleep cycle counting device 100 will be mainly described.

The electronic tag device 30 according to an exemplary embodiment of the present disclosure may include a communications unit 200 communicating with the server 10 through the gateway 20, an oscillating unit 300 outputting an oscillating signal, a sleep cycle counting unit 400 outputting a wakeup or a sleep signal, and a controlling unit 500 switching the communications unit 200 to a wakeup or sleep mode according to the wakeup or the sleep signal.

The communications unit 200 may be switched to a wakeup mode by the controlling unit 500 and communicate with the server 10.

The oscillating unit 300 may generate the oscillating signal and output the same to the sleep cycle counting unit 400. Here, the oscillating unit 110 may include an RC oscillator configured of resistance and capacitance. Here, the oscillating unit 110 may correct a frequency of the oscillating signal by adjusting the resistance and capacitance values.

The sleep cycle counting unit 400 may set a sleep cycle, divide an output frequency of the oscillating signal according to the sleep cycle, and count the number of clocks in the divided oscillating signal to thereby output the wakeup or the sleep signal.

According to an exemplary embodiment of the present disclosure, the sleep cycle counting unit 400 may include a dividing unit 410, a sleep cycle setting unit 420, a dividing ratio controlling unit 430, and a sleep mode controlling unit 440 outputting the wakeup or the sleep signal, as shown in FIG. 7.

Specifically, the sleep cycle counting unit 400 may include the dividing unit 410 dividing an oscillating signal, the sleep cycle setting unit 420 setting a sleep cycle, the dividing ratio controlling unit 430 varying a dividing ratio of the dividing unit according to the sleep cycle, and the sleep mode controlling unit 440 outputting the wakeup or the sleep signal by counting the number of clocks in the divided oscillating signal.

The dividing unit 410 may divide the oscillating signal received from the oscillating unit 300 and output the divided oscillating signal to the sleep mode controlling unit 440. Here, the dividing unit 410 may divide the oscillating signal at a dividing ratio varied by the dividing ratio controlling unit 430.

The sleep cycle setting unit 420 may set a sleep cycle and output the same to the dividing ratio controlling unit 430. Here, the sleep cycle setting unit 420 may set the sleep cycle corresponding to sleep mode information which is input from the outside or is preset.

The dividing ratio controlling unit 430 may vary the dividing ratio of the dividing unit 410 according to the sleep cycle set by the sleep cycle setting unit 420.

According to an exemplary embodiment of the present disclosure, the dividing ratio controlling unit 430 may vary the dividing ratio in proportion to the sleep cycle set by the sleep cycle setting unit 420.

According to another exemplary embodiment of the present disclosure, the sleep cycle counting unit 400 may further include a lookup table 142 including dividing ratio information according to the sleep cycle. Here, the dividing ratio controlling unit 430 may vary the dividing ratio according to the dividing ratio information stored in the lookup table 142.

The sleep mode controlling unit 440 may count the number of clocks in the oscillating signal divided by the dividing unit 410 and output the wakeup or the sleep signal to the controlling unit 500.

Here, when the sleep mode controlling unit 440 counts the oscillating signal divided by the dividing unit 410, an operating current flows to thereby cause power consumption. Therefore, as the sleep cycle is increased, the sleep mode controlling unit 440 counts the oscillating signal divided at an increased dividing ratio value such that the number of counting is reduced, whereby the power consumption may be significantly reduced.

The controlling unit 500 may switch the communications unit 200 to the wakeup or sleep mode according to the wakeup or the sleep signal output from the sleep mode controlling unit 440.

As set forth above, according to exemplary embodiments of the present disclosure, the number of counting is reduced by counting an oscillating signal divided by a dividing ratio varied according to a sleep cycle, whereby power consumption may be significantly reduced.

While exemplary embodiments have been shown and described above, it will be apparent to those skilled in the art that modifications and variations could be made without departing from the spirit and scope of the present disclosure as defined by the appended claims.

## Claims

1. A sleep cycle counting device, comprising:
an oscillating unit configured to receive a voltage having a predetermined level and output an oscillating signal;
a dividing unit configured to divide the oscillating signal;
a sleep cycle setting unit configured to set a sleep cycle;
a dividing ratio controlling unit configured to vary a dividing ratio of the dividing unit according to the sleep cycle; and
a sleep mode controlling unit configured to count the number of clocks in the divided oscillating signal and output a wakeup or a sleep signal.

2. The sleep cycle counting device of claim 1, wherein the dividing ratio controlling unit varies the dividing ratio in proportion to the sleep cycle.

3. The sleep cycle counting device of claim 1, further comprising a lookup table including dividing ratio information according to the sleep cycle,
wherein the dividing ratio controlling unit varies the dividing ratio according to the dividing ratio information stored in the lookup table.

4. The sleep cycle counting device of claim 1, wherein the oscillating unit is an RC oscillator.

5. A sleep cycle counting method, comprising:
setting a sleep cycle;
varying a dividing ratio according to the sleep cycle;
dividing an oscillating signal using the dividing ratio;
counting the number of clocks in the divided oscillating signal; and
outputting a wakeup signal when a sleep time according to the sleep cycle expires as a result of counting the number of clocks.

6. The sleep cycle counting method of claim 5, further comprising:
counting the number of clocks in the divided oscillating signal after the outputting of the wakeup signal; and
outputting a sleep signal when a wakeup time according to the sleep cycle expires as a result of counting the number of clocks.

7. An electronic tag device, comprising:
a communications unit configured to communicate with a server;
an oscillating unit configured to receive a voltage having a predetermined level and output an oscillating signal;
a sleep cycle counting unit configured to set a sleep cycle of the communications unit, divide an output frequency of the oscillating signal according to the sleep cycle, and count the number of clocks in the divided oscillating signal to output a wakeup or a sleep signal; and
a controlling unit configured to switch the communications unit to a wakeup or a sleep mode according to the the wakeup or the sleep signal output by the sleep cycle counting unit.

8. The electronic tag device of claim 7, wherein the sleep cycle counting unit includes:
a dividing unit configured to divide the oscillating signal;
a sleep cycle setting unit configured to set the sleep cycle;
a dividing ratio controlling unit configured to vary the dividing ratio of the diving unit according to the sleep cycle; and
a sleep mode controlling unit configured to count the number of clocks in the divided oscillating signal and output the wakeup or the sleep signal.

9. The electronic tag device of claim 8, wherein the dividing ratio controlling unit varies the dividing ratio in proportion to the sleep cycle.

10. The electronic tag device of claim 8, wherein the dividing ratio controlling unit includes a lookup table including dividing ratio information according to the sleep cycle and varies the dividing ratio according to the dividing ratio information stored in the lookup table.

11. The electronic tag device of claim 7, wherein the oscillating unit is an RC oscillator.
